(19) Europäisches Patentamt
European Patent Office
Office européen des brevets

(11) **EP 4 764 525 A1**

(12) **EUROPEAN PATENT APPLICATION**

(43) Date of publication:
24.06.2026 Bulletin 2026/26

(21) Application number: 25184809.9

(22) Date of filing: **24.06.2025**

(51) International Patent Classification (IPC):
**G01R 31/367** (2019.01)   **G01R 31/382** (2019.01)
**G01R 31/392** (2019.01)

(52) Cooperative Patent Classification (CPC):
**G01R 31/367; G01R 31/382; G01R 31/392**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **17.12.2024 KR 20240189163**

(71) Applicants:
• **Hyundai Motor Company**
**Seoul 06797 (KR)**

• **Kia Corporation**
**Seoul 06797 (KR)**

(72) Inventors:
• **LEE, Woo Ju**
**18280 Hwaseong-si (KR)**
• **KIM, Min Joo**
**18280 Hwaseong-si (KR)**

(74) Representative: **Viering, Jentschura & Partner
mbB**
**Patent- und Rechtsanwälte**
**Am Brauhaus 8**
**01099 Dresden (DE)**

(54) **BATTERY DIAGNOSTIC APPARATUS AND METHOD**

(57)     A battery diagnostic apparatus includes a processor. The processor determines ideal data for predicting a state of health (SOH) of a battery of a vehicle, based on first vehicle data obtained from the vehicle while the vehicle driving. The battery diagnostic apparatus further includes real data for measuring the SOH of the battery, based on battery data measured in one or more state of charge (SOC) intervals of the battery. The battery diagnostic apparatus further includes diagnoses a state of the battery based on the ideal data and the real data.

FIG.1

**Description**

## CROSS-REFERENCE TO RELATED APPLICATION

This application claims the benefit of and priority to Korean Patent Application No. 10-2024-0189163, filed in the Korean Intellectual Property Office on December 17, 2024, the entire contents of which are incorporated herein by reference.

## TECHNICAL FIELD

The present disclosure relates to a battery diagnostic apparatus and a battery diagnostic method, and more particularly, the present disclosure relates to technologies for diagnosing a deterioration state of a battery.

## BACKGROUND

An electric vehicle may receive electricity from the outside to charge its battery and may discharge the battery to drive its motor. Thus, the motor may obtain power. The battery undergoes internal deformation and metamorphosis through various charging and discharging in the production and usage stage and may change in physicochemical characteristic. There may be a need for a technology for managing a state of the battery due to such degradation and deterioration of the battery. State of charge (SOC) and state of health (SOH) estimation algorithms may be loaded into a battery management system (BMS) to provide a state of the battery. However, data available for algorithm calculation may be limited. When an SOH is estimated based on limited data and computing power, a problem may occur in terms of accuracy and real-time performance. Thus, there is a need for a method for improving the accuracy of SOH estimation using past driving history data and relatively many analytical resources. The subject matter described in this background section is intended to promote an understanding of the background of the disclosure and thus may include subject matter that is not already known to those of ordinary skill in the art.

## SUMMARY

The present disclosure has been made to solve the above-mentioned problems occurring in the prior art while advantages achieved by the prior art are maintained intact.
An aspect of the present disclosure provides a battery diagnostic apparatus for updating vehicle data to diagnose a deterioration state of a battery and a method thereof.
Another aspect of the present disclosure provides a battery diagnostic apparatus for comparing a predicted value for a deterioration degree of a battery with a measured value for the deterioration degree of the battery based on a driving history to diagnose a state of the battery and a method thereof.
The technical problems to be solved by the present disclosure are not limited to the aforementioned problems. Any other technical problems not mentioned herein should be clearly understood from the following description by those having ordinary skill in the art to which the present disclosure pertains.
According to an aspect of the present disclosure, a battery diagnostic apparatus may include a processor. The processor may determine ideal data for predicting a state of health (SOH) of a battery of a vehicle, based on first vehicle data obtained from the vehicle while the vehicle driving. The processor may determine real data for measuring the SOH of the battery, based on battery data measured in one or more state of charge (SOC) intervals of the battery. The processor may diagnose a state of the battery based on the ideal data and the real data. The processor may update a first capacity table by overwriting a second discharge capacity dataset on a first discharge capacity dataset assigned to a first layer of the first capacity table and moving the first discharge capacity dataset from the first layer of the first capacity table to a second layer of the capacity table. The processor may obtain a second capacity table in response to the updated first layer of the first capacity table. The first discharge capacity dataset indicates discharge capacity for an SOC interval used while the vehicle is driving

For example, the processor may determine the ideal data, based on at least one of a usage time of the vehicle, a mileage of the vehicle, a parking time of the vehicle, a parking temperature of the vehicle, the SOC, a charge rate (C-rate) of the vehicle, a charge temperature of the vehicle, or any combination thereof. The usage time, the mileage, the parking time, the parking temperature, the SOC, the C-rate, and the charge temperature are obtained based on the first vehicle data.
For example, the processor may obtain the second discharge capacity dataset after obtaining the first discharge capacity dataset. The processor may determine the real data by using the second discharge capacity dataset updated in a first layer and the first discharge capacity dataset moved to the second layer. The first layer of the first capacity table and the second layer of the first capacity table indicate the battery data. The battery data may include at least one of the discharge capacity for each of the one or more SOC intervals, battery resistance for each of the one or more SOC intervals, or any combination thereof.

For example, the processor may determine whether second vehicle data obtained after obtaining the first vehicle data meets predetermined criteria.

For example, the processor may determine whether to update the first discharge capacity dataset corresponding to the first vehicle data to the second discharge capacity dataset corresponding to the second vehicle data, when the second vehicle data meets the predetermined criteria.

For example, the processor may extract a representative value for the one or more SOC intervals from the battery data, based on at least one of a first layer including the first discharge capacity dataset or a second layer including the second discharge capacity dataset, or any combination thereof. The processor may determine the real data, based on the representative value.

For example, the processor may select the one or more SOC intervals for obtaining the real data, using predetermined information.

For example, the processor may diagnose the state of the battery as a normal state, when a difference between the ideal data and the real data is within a normal range.

For example, the processor may diagnose the state of the battery as an abnormal state, when a difference between the ideal data and the real data is beyond a normal range.

For example, the processor may determine a deterioration degree of the battery according to the mileage, using at least one of temperature data of the battery, the mileage, current data of the battery, or any combination thereof. The temperature data, the mileage, and the current data are included in the first vehicle data, and may determine the ideal data, based on the deterioration degree of the battery according to the mileage.

For example, the processor may determine a deterioration degree of the battery according to the usage time, using at least one of SOC data of the battery, the usage time, temperature data of the battery, or any combination thereof. The SOC data, the usage time, and the temperature data are included in the first vehicle data. The processor may determine the ideal data, based on the deterioration degree of the battery according to the usage time.

According to another aspect of the present disclosure, a battery diagnostic method may include determining ideal data for predicting a state of health (SOH) of a battery of a vehicle, based on first vehicle data obtained from the vehicle while the vehicle driving. The battery diagnostic method may include determining real data for measuring the SOH of the battery, based on battery data measured in one or more state of charge (SOC) intervals of the battery. The battery diagnostic method may include diagnosing a state of the battery based on the ideal data and the real data. The battery diagnostic method may include updating a first capacity table by overwriting a second discharge capacity dataset on a first discharge capacity dataset assigned to a first layer of the first capacity table and moving the first discharge capacity dataset from the first layer of the first capacity table to a second layer of the capacity table. The battery diagnostic method may include obtaining a second capacity table in response to the updated first layer of the first capacity table. The first discharge capacity dataset indicates discharge capacity for an SOC interval used while the vehicle is driving.

For example, determining the ideal data may include determining the ideal data, based on at least one of a usage time of the vehicle, a mileage of the vehicle, a parking time of the vehicle, a parking temperature of the vehicle, the SOC, a charge rate of the vehicle, a charge temperature of the vehicle, or any combination thereof. The usage time, the mileage, the parking time, the parking temperature, the SOC, the charge rate, and the charge temperature are obtained based on the first vehicle data.

For example, determining the ideal data may include obtaining the second discharge capacity dataset after obtaining the first discharge capacity dataset. Determining the ideal data may include determining the real data by using the second discharge capacity dataset updated in a first layer and the first discharge capacity dataset moved to the second layer. The first layer of the first capacity table and the second layer of the first capacity table indicate the battery data. The battery data may include at least one of the discharge capacity for each of the one or more SOC intervals, battery resistance for each of the one or more SOC intervals, or any combination thereof.

For example, the battery diagnostic method may further include determining whether second vehicle data obtained after obtaining the first vehicle data meets predetermined criteria.

For example, determining the ideal data may include determining whether to update the first discharge capacity dataset corresponding to the first vehicle data to the second discharge capacity dataset corresponding to the second vehicle data, when the second vehicle data meets the predetermined criteria.

For example, determining the ideal data may include extracting a representative value for the one or more SOC intervals from the battery data, based on at least one of a first layer including the first discharge capacity dataset, a second layer including the second discharge capacity dataset, or any combination thereof. Determining the ideal data may include determining the real data, based on the representative value.

For example, diagnosing the state of the battery may include diagnosing the state of the battery as a normal state, when a difference between the ideal data and the real data is within a normal range.

For example, diagnosing the state of the battery may include diagnosing the state of the battery as an abnormal state, when a difference between the ideal data and the real data is beyond a normal range.

For example, determining the ideal data may include determining a deterioration degree of the battery according to the mileage, using at least one of temperature data of the battery, the mileage, current data of the battery, or any combination thereof. The temperature data, the mileage, and the current data are included in the first vehicle data. Determining the ideal data may include determining the ideal data, based on the deterioration degree of the battery according to the mileage.

## BRIEF DESCRIPTION OF THE DRAWINGS

The above and other objects, features, and advantages of the present disclosure should be more apparent from the following detailed description taken in conjunction with the accompanying drawings:

FIG. 1 illustrates a block diagram associated with a battery diagnostic apparatus according to an embodiment of the present disclosure;

FIG. 2 illustrates a flowchart illustrating an operation of obtaining vehicle data in a battery diagnostic apparatus according to an embodiment of the present disclosure;

FIG. 3 illustrates a flowchart illustrating an operation of preprocessing vehicle data in a battery diagnostic apparatus according to an embodiment of the present disclosure;

FIG. 4 illustrates a flowchart illustrating an operation of determining a state of health (SOH) of a battery in a battery diagnostic apparatus according to an embodiment of the present disclosure;

FIG. 5 illustrates a flowchart illustrating an operation of diagnosing a state of a battery in a battery diagnostic apparatus according to an embodiment of the present disclosure;

FIG. 6 illustrates discharge capacity for each state of charge (SOC) interval, which is obtained by a battery diagnostic apparatus according to an embodiment of the present disclosure;

FIG. 7 illustrates a capacity table obtained by a battery diagnostic apparatus according to an embodiment of the present disclosure;

FIG. 8 illustrates an SOC interval for determining an SOH of a battery, which is identified by a battery diagnostic apparatus according to an embodiment of the present disclosure;

FIG. 9 illustrates a table illustrating ideal data and real data obtained by a battery diagnostic apparatus according to an embodiment of the present disclosure;

FIG. 10 illustrates a graph illustrating a deterioration history of a battery, which is identified by a battery diagnostic apparatus according to an embodiment of the present disclosure;

FIG. 11 illustrates a flowchart illustrating a battery diagnostic method according to an embodiment of the present disclosure; and

FIG. 12 illustrates a computing system associated with a battery diagnostic apparatus or a battery diagnostic method according to an embodiment of the present disclosure.

## DETAILED DESCRIPTION

Hereinafter, some embodiments of the present disclosure are described in detail with reference to the drawings. In adding the reference numerals to the components of each drawing, it should be noted that the identical or equivalent components are designated by the identical numerals even when the components are displayed on other drawings. Further, in describing the embodiment of the present disclosure, a detailed description of well-known features or functions has been omitted in order not to unnecessarily obscure the gist of the present disclosure.

In describing components of embodiments of the present disclosure, the terms first, second, A, B, (a), (b), and the like may be used herein. These terms are only used to distinguish one component from another component. However, the terms do not limit the corresponding components irrespective of the order or priority of the corresponding components. Furthermore, unless otherwise defined, all terms including technical and scientific terms used herein have the same meaning as being generally understood by those having ordinary skill in the art to which the present disclosure pertains. Such terms as those defined in a generally used dictionary should be interpreted as having meanings equal to the contextual meanings in the relevant field of art. The terms should not be interpreted as having ideal or excessively formal meanings unless clearly defined as having such in the present application.

In the present disclosure, each of phrases such as "A or B", "at least one of A and B", "at least one of A or B", "A, B or C", "at least one of A, B and C", "at least one of A, B or C" and "at least one of A, B, or C, or a combination thereof" may include any one or all possible combinations of the items listed together in the corresponding one of the phrases.

The term "module" used in various embodiments of the present disclosure may include a unit implemented with hardware, software, or firmware and may be interchangeably used with terms, for example, "logic," "logic block," "part," or "circuitry". A module may be an integral part, a minimum unit thereof, or a portion thereof configured to perform one or more functions. In an embodiment, the module may be implemented in the form of an application-specific integrated circuit (ASIC). According to various embodiments, operations performed by the module, the program, or another component may be carried out sequentially, in parallel, or repeatedly. Alternatively, one or more of the operations may be executed in a different order or omitted. Alternatively, one or more other operations may be added. When a controller, apparatus, module, component, device, element, logic, logic block, part, circuitry, or the like of the present disclosure is described as having a purpose or performing an operation, function, or the like, the controller, apparatus, module, component, device, element, logic, logic block, part, circuitry, or the like should be considered herein as being "configured to" meet that purpose or to perform that operation or function. Each controller, apparatus, module, component, device, element, logic, logic block, part, circuitry, and the like may separately embody or be included with a processor and a memory, such as a non-transitory computer readable media, as part of the apparatus.

Various embodiments of the present disclosure may be implemented as software (e.g., a program) including one or more instructions stored in a storage medium (e.g., an internal memory or an external memory) readable by a machine (e.g., a battery diagnostic apparatus 100). For example, a processor (e.g., a processor 110) of the device (e.g., the battery diagnostic apparatus 100) may invoke at least one of the stored one or more instructions from the storage medium and may execute the instructions. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Here, the term "non-transitory" simply means that the storage medium is a tangible device and does not include a signal (e.g., an electromagnetic wave). However, this term does not differentiate data semi-permanently stored in the storage medium and data temporarily stored in the storage medium.

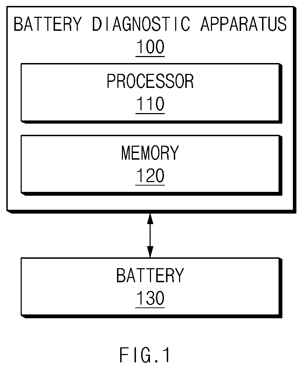

Hereinafter, embodiments of the present disclosure are described in detail with reference to FIGS. 1-12.

FIG. 1 illustrates a block diagram associated with a battery diagnostic apparatus according to an embodiment of the present disclosure.

Referring to FIG. 1, a battery diagnostic apparatus 100 according to an embodiment of the present disclosure may be implemented inside or outside a battery 130, and some of the components included in the battery diagnostic apparatus 100 may be implemented inside or outside the battery 130. In this case, the battery diagnostic apparatus 100 may be integrally configured with control units in the battery 130 or may be implemented as a separate device to be connected to the control units of the battery 130 by a separate connection means. For example, the battery diagnostic apparatus 100 may further include components, which are not shown in FIG. 1.

The following operation of the battery diagnostic apparatus 100 may be performed by a battery management system (BMS) and may be performed in various devices, such as a server, a cloud, cloud computing, a charger, or a charger and discharger. For convenience of description, a description is given on the premise that the battery diagnostic apparatus 100 is configured as another device outside the battery 130.

The battery diagnostic apparatus 100 according to an embodiment may include at least one of a processor 110 or a memory 120. The processor 110 and the memory 120 may be electronically or operably coupled with each other by an electronical component including a communication bus. Hereinafter, the pieces of hardware are operably coupled with each other may mean that a direct connection or an indirect connection between the pieces of hardware is established in a wired or wireless manner, such that second hardware is controlled by first hardware among the pieces of hardware. The pieces of hardware are illustrated based on the different blocks, but an embodiment is not limited thereto. Some of the pieces of hardware of FIG. 1 (e.g., at least some of the processor 110, the memory 120, and a communication circuit) may be included in a single integrated circuit such as a system on a chip (SoC).

The processor 110 of the battery diagnostic apparatus 100 according to an embodiment may include a hardware component for processing data based on one or more instructions. The hardware component for processing the data may include, for example, an arithmetic and logic unit (ALU), a floating point unit (FPU), a field programmable gate array (FPGA), a central processing unit (CPU), a micro controlling unit (MCU), and/or an application processor (AP). The number of the processors 110 may be one or more in number. For example, the processor 110 may have a structure of a multi-core processor including a dual core, a quad core, a hexa core, or an octa core.

The memory 120 of the battery diagnostic apparatus 100 according to an embodiment may include a hardware component for storing data and/or instructions input and/or output from the processor 110. The memory 120 may include, for example, a volatile memory, such as a random-access memory (RAM), and/or a non-volatile memory, such as a read-only memory (ROM). For example, the volatile memory may include at least one of a dynamic RAM (DRAM), a static RAM (SRAM), a cache RAM, or a pseudo SRAM (PSRAM). For example, the non-volatile memory may include at least one of a programmable ROM (PROM), an erasable PROM (EPROM), an electrically erasable PROM (EEPROM), a flash memory, a hard disk, a compact disc, or an embedded multi-media card (eMMC). The processor 110 and/or the memory 120 may be associated with a battery management system (BMS) for managing the battery 130.

In an embodiment, the battery 130 may include at least one battery cell capable of being charged and/or discharged. Herein, the at least one battery cell may be a basic unit of the battery, which may charges and discharges electric energy to use the electric energy. For example, the at least one battery cell may be, but is not limited to, a lithium-ion (Li-ion) battery, a Li-ion polymer battery, a nickel-cadmium (Ni-Cd) battery, a nickel-metal hydride (Ni-MH) battery, or the like. For example, the battery 130 may be included in a vehicle.

The battery diagnostic apparatus 100 according to an embodiment may use vehicle data obtained while the vehicle is driving to determine ideal data for predicting a state of health (SOH) of the battery 130, based on at least one of a usage time of the vehicle, a mileage of the vehicle, or any combination thereof.

For example, when the battery diagnostic apparatus 100 is disposed in the vehicle, it may obtain vehicle data via a sensor of the vehicle. For example, when the battery diagnostic apparatus 100 is disposed outside the vehicle, the battery diagnostic apparatus 100 may receive vehicle data from the vehicle to obtain the vehicle data.

For example, the usage time of the vehicle may include a time interval from a time point when the battery 130 of the vehicle is used to a time point when the vehicle data is obtained. For example, the mileage of the vehicle may include an accumulated mileage of the vehicle.

In an embodiment, the vehicle data may include battery data indicating a state of charge (SOC) of the battery 130, voltage data of the battery 130, current data of the battery 130, and/or temperature data of the battery 130. The vehicle data may include a mileage of the vehicle and/or a usage time of the vehicle. The vehicle data may include state of charge (SOC) data of the battery 130 and/or battery data measured in one or more SOC intervals (or in each of the one or more SOC intervals). For example, the battery data may include at least one of discharge capacity for each SOC interval, battery resistance for each SOC interval, or any combination thereof.

In an embodiment, the vehicle data may include parking data obtained while the vehicle is parking. The vehicle data may include parking data including a parking time, a parking temperature, and/or an SOC during parking, which are obtained while the vehicle is parking. For example, the vehicle data may include charge data including a charge rate (C-rate) for charging (or discharging) the battery and/or a charge temperature.

In an embodiment, the vehicle data may include data corresponding to one-time driving of the vehicle (e.g., including from initiation of driving of the vehicle to end of the driving of the vehicle). The battery diagnostic apparatus 100 may determine that the vehicle is ignition on to determine the initiation of the driving of the vehicle. The battery diagnostic apparatus 100 may determine that the vehicle is ignition off to determine the end of the driving of the vehicle.

For example, the battery diagnostic apparatus 100 may obtain vehicle data via a sensor, during one driving cycle including a time point when the vehicle initiates to drive and a time point when the vehicle ends the driving. The obtained vehicle data may correspond to one driving cycle.

The battery diagnostic apparatus 100 according to an embodiment may determine real data for measuring a state of health (SOH), based on a capacity table including discharge capacity for each SOC interval in the battery 130.

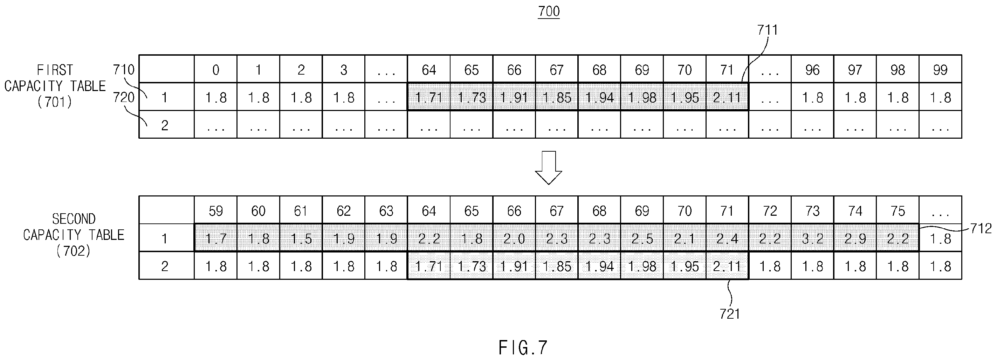

For example, the capacity table may comprise a two-dimensional (2D) matrix including one or more layers indicating discharge capacity for each SOC interval. An example of the capacity table is described below with reference to FIG. 7.

The battery diagnostic apparatus 100 according to an embodiment may diagnose a state of the battery 130 based on the ideal data and the real data.

For example, the ideal data (e.g., a model SOH) may change according to a driving history of the vehicle. The real data may change according to a recent driving history of the vehicle. When the battery diagnostic apparatus 100 is disposed outside the vehicle (e.g., when the battery diagnostic apparatus 100 is a server), the real data may be referred to as a cloud SOH in terms of being obtained by the external server. The real data may be referred to as a measured value in terms of being actually measured using recent vehicle data of the vehicle.

In an embodiment, the ideal data may indicate a deterioration degree according to the usage time of the vehicle and/or a deterioration degree according to the mileage of the vehicle.

For example, the battery diagnostic apparatus 100 may determine the deterioration degree of the battery 130 according to the mileage, using at least one of the temperature data of the battery 130, the mileage, the current data of the battery 130, which is included in the vehicle data, or any combination thereof. The battery diagnostic apparatus 100 may determine the ideal data, based on the deterioration degree of the battery 130 according to the mileage. For example, the ideal data may be referred to as a reference value or a predicted value for comparing a state of the battery 130.

For example, the battery diagnostic apparatus 100 may determine the deterioration degree of the battery 130 according to the usage time, using at least one of the SOC data of the battery 130, the usage time, the temperature data of the battery 130, which is included in the vehicle data, or any combination thereof. For example, the battery diagnostic apparatus 100 may determine the ideal data, based on the deterioration degree of the battery 130 according to the mileage.

In an embodiment, the battery diagnostic apparatus 100 may compare the ideal data with the real data to diagnose a state of the battery 130.

For example, when a difference between the ideal data and the real data is less than or equal to a threshold, the battery diagnostic apparatus 100 may diagnose the state of the battery 130 as a normal state. For example, when the difference between the ideal data and the real data is greater than the threshold, the battery diagnostic apparatus 100 may diagnose the state of the battery 130 as an abnormal state.

For example, the battery diagnostic apparatus 100 may provide the diagnosed result of diagnosing the battery 130. For example, the battery diagnostic apparatus 100 may transmit the diagnosed result to the vehicle to provide the diagnosed result using a display of the vehicle. For example, the battery diagnostic apparatus 100 may transmit the diagnosed result to a user terminal (e.g., a smartphone) to provide the diagnosed result using a display of the user terminal.

As described above, the battery diagnostic apparatus 100 according to an embodiment may determine an SOH of the battery 130 based on relatively much information, using vehicle data (or driving history data) of a separate vehicle. For example, the battery diagnostic apparatus 100 may use vehicle data corresponding to any SOC interval to provide a service capable of more accurately determining an SOH. The battery diagnostic apparatus 100 may early diagnose the state of the battery 130, before a fault of the battery 130 substantially occurs, using the difference between the ideal data and the real data.

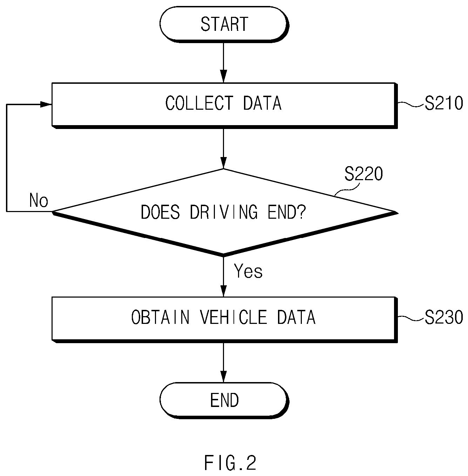

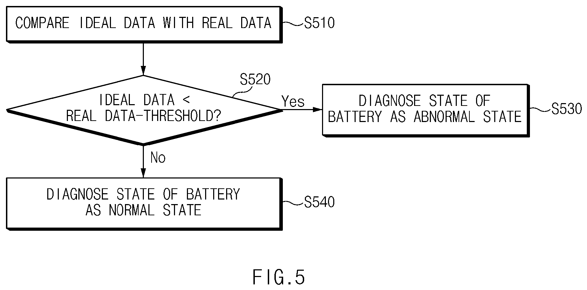

FIG. 2 illustrates a flowchart illustrating an operation of obtaining vehicle data in a battery diagnostic apparatus according to an embodiment of the present disclosure. Hereinafter, it is assumed that a battery diagnostic apparatus 100 of FIG. 1 performs processes of FIGS. 2 and 5. Furthermore, in descriptions of FIGS. 2 and 5, it may be understood that an operation described as being performed by a battery diagnostic apparatus is controlled by a processor 110 of the battery diagnostic apparatus 100. The respective operations of FIGS. 2-5 may be sequentially performed but are not necessarily sequentially performed. For example, an order of the respective operations may be changed, and at least two operations may be performed in parallel.

Referring to FIG. 2, in S210, the battery diagnostic apparatus according to an embodiment may collect (or obtain) sensing data via a sensor, while a vehicle is driving. The battery diagnostic apparatus may obtain temperature data of a battery, voltage data of the battery, and/or current data of the battery via the sensor. However, it is not limited thereto.

Referring to FIG. 2, in S220, the battery diagnostic apparatus according to an embodiment may determine whether the driving of the vehicle ends. For example, when the driving of the vehicle does not end (S220 - No), the battery diagnostic apparatus may keep performing S210.

Referring to FIG. 2, when the driving of the vehicle ends (S220 - Yes), in S230, the battery diagnostic apparatus according to an embodiment may obtain vehicle data including the sensing data obtained while the vehicle is driving.

For example, when the battery diagnostic apparatus is disposed outside the vehicle, it may receive vehicle data from the vehicle. However, it is not limited thereto.

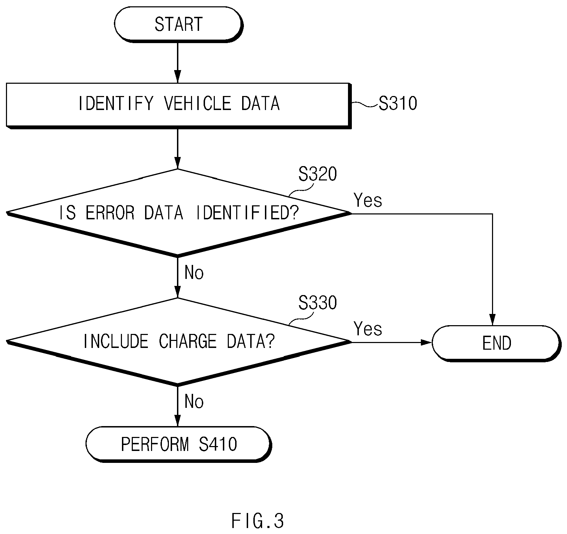

FIG. 3 illustrates a flowchart illustrating an operation of preprocessing vehicle data in a battery diagnostic apparatus according to an embodiment of the present disclosure. At least one of the operations of FIG. 3 may be associated with at least one of the operations of FIG. 2.

Referring to FIG. 3, in S310, the battery diagnostic apparatus according to an embodiment may determine vehicle data. The vehicle data may be obtained as the battery diagnostic apparatus performs S230 of FIG. 2. At least one of the operations of FIG. 3 may indicate a preprocessing operation for removing error data from the vehicle data.

Referring to FIG. 3, in S320, the battery diagnostic apparatus according to an embodiment may determine whether error data is included in the vehicle data. For example, when the error data is included in the vehicle data (S320 - Yes), the battery diagnostic apparatus may end performing the operation of preprocessing the vehicle data. For example, when the error data is identified (S320 - Yes), the battery diagnostic apparatus may remove the error data from the vehicle data.

In an embodiment, the battery diagnostic apparatus may determine whether a voltage of a battery, which is included in the vehicle data, falls between a voltage upper limit value and a voltage lower limit value.

For example, when the voltage of the battery does not fall between the voltage upper limit value and the voltage lower limit value, the battery diagnostic apparatus may end the operation of preprocessing the vehicle data.

For example, when the voltage of the battery does not fall between the voltage upper limit value and the voltage lower limit value, the battery diagnostic apparatus may remove error data indicating the voltage of the battery, which does not fall between the voltage upper limit value and the voltage lower limit value.

In an embodiment, the battery diagnostic apparatus may determine whether a current of the battery, which is included in the vehicle data, falls between a current upper limit value and a current lower limit value.

For example, when the current of the battery does not fall between the current upper limit value and the current lower limit value, the battery diagnostic apparatus may end the operation of preprocessing the vehicle data.

For example, when the current of the battery does not fall between the current upper limit value and the current lower limit value, the battery diagnostic apparatus may remove error data indicating the current of the battery, which does not fall between the current upper limit value and the current lower limit value.

In an embodiment, the battery diagnostic apparatus may determine whether a temperature of the battery, which is included in the vehicle data, falls between a temperature upper limit value and a temperature lower limit value.

For example, when the temperature of the battery does not fall between the temperature upper limit value and the temperature lower limit value, the battery diagnostic apparatus may end the operation of preprocessing the vehicle data.

For example, when the temperature of the battery does not fall between the temperature upper limit value and the temperature lower limit value, the battery diagnostic apparatus may remove error data indicating the temperature of the battery, which does not fall between the temperature upper limit value and the temperature lower limit value.

Referring to FIG. 3, upon determining that no error data is present in step S320 (i.e., No), the battery diagnostic apparatus may determine whether the vehicle data includes charge data in step S330.

For example, the charge data may include data obtained while the battery is being charged. For example, when the vehicle data includes the charge data, the state of the battery may be a state of charge (SOC). For example, when the vehicle data includes the charge data (S330 - Yes), the battery diagnostic apparatus may end performing the operation of preprocessing the vehicle data. However, it is not limited thereto.

Referring to FIG. 3, when the vehicle data does not include the charge data (S330 - No), the battery diagnostic apparatus according to an embodiment may perform step S410.

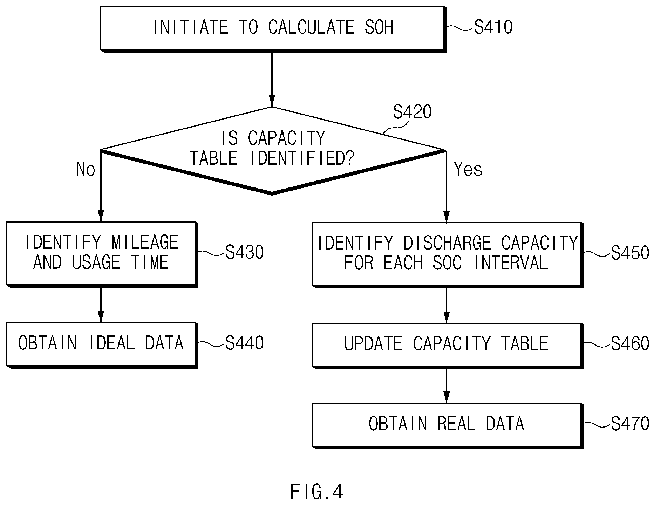

FIG. 4 illustrates a flowchart illustrating an operation of determining a state of health (SOH) of a battery in a battery diagnostic apparatus according to an embodiment of the present disclosure. At least one of the operations of FIG. 4 may be associated with at least one of the operations of FIGS. 2 and 3.

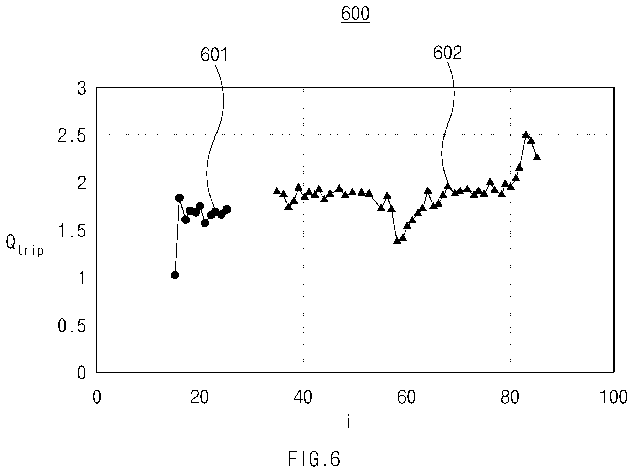

FIG. 6 illustrates discharge capacity for each state of charge (SOC) interval, which is obtained by a battery diagnostic apparatus according to an embodiment of the present disclosure.

FIG. 7 illustrates a capacity table obtained by a battery diagnostic apparatus according to an embodiment of the present disclosure.

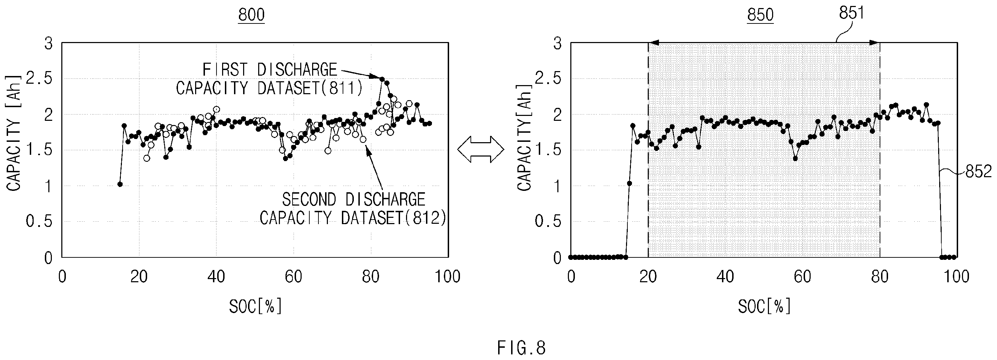

FIG. 8 illustrates an SOC interval for determining an SOH of a battery identified by a battery diagnostic apparatus according to an embodiment of the present disclosure.

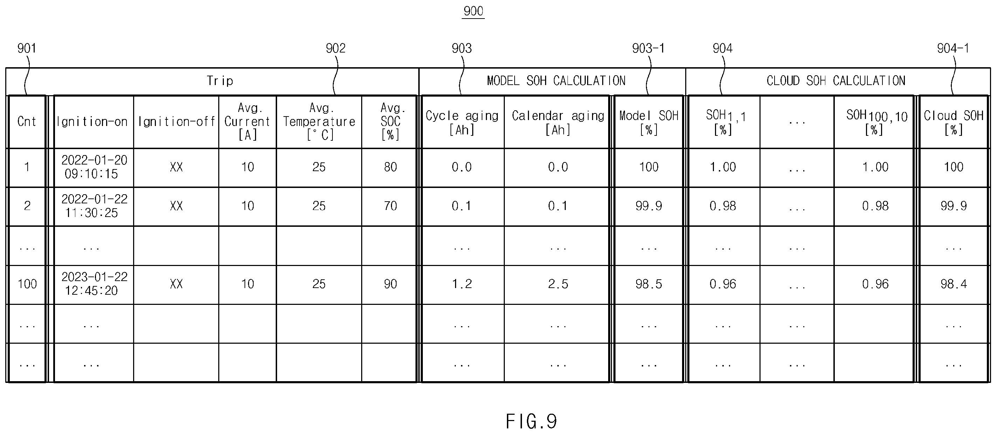

FIG. 9 illustrates a table illustrating ideal data and real data obtained by a battery diagnostic apparatus according to an embodiment of the present disclosure.

Referring to FIG. 4, in S410, the battery diagnostic apparatus according to an embodiment may initiate to calculate an SOH of a battery. The battery diagnostic apparatus may initiate to calculate the SOH using vehicle data.

According to an embodiment, referring to FIG. 4, the battery diagnostic apparatus may determine whether a capacity table is identified in step S420. For example, the battery diagnostic apparatus may determine whether the capacity table is required to calculate the SOH.

Referring to FIG. 4, when the capacity table is not required to calculate the SOH (S420 - No), the battery diagnostic apparatus according to an embodiment may determine a mileage and a usage time in step S430. For example, when the capacity table is not identified or determined (i.e., "No" in S420), the battery diagnostic apparatus according to an embodiment may determine the mileage and the usage time in S430.

Referring to FIG. 4, in S440, the battery diagnostic apparatus according to an embodiment may obtain (or determine) ideal data for predicting an SOH of the battery, using a deterioration degree of the battery according to the mileage and a deterioration degree of the battery according to the usage time.

For example, the battery diagnostic apparatus may determine a deterioration degree of the battery according to at least one of a usage time of a vehicle, a mileage of the vehicle, a parking time of the vehicle, a parking temperature of the vehicle, an SOC of the vehicle, a charge-rate (C-rate), a charge temperature of the vehicle, or any combination thereof.

For example, before performing S440, the battery diagnostic apparatus may determine an SOH of the battery at a time point before being accumulated (or stored) in its memory. However, it is not limited thereto.

In an embodiment, the battery diagnostic apparatus may obtain the deterioration degree of the battery according to the mileage using Equation 1 below.

[Equation 1]

$$f_1(I, T, L) = a_1\, exp\big((a_2|I| + a_3)/T\big)\, L^{a_4}$$

$f_1(I,T,L)$ may indicate the deterioration degree of the battery according to the mileage. $I$ may indicate the current data of the battery. $T$ may indicate the temperature data of the battery. $L$ may indicate the mileage of the vehicle. $a_1$ may be the coefficient indicating the influence degree of the current of the battery, the temperature of the battery, and the mileage of the vehicle on the deterioration degree of the battery. $a_2$ may be the coefficient indicating the influence degree of the current of the battery on the deterioration degree of the battery. $a_3$ may be the coefficient indicating the influence degree of the temperature of the battery on the deterioration degree of the battery. $a_4$ may be the coefficient indicating the influence degree of the mileage on the deterioration degree of the battery. In other words, the battery diagnostic apparatus may determine the deterioration degree of the battery according to the mileage, using at least one of the temperature data of the battery, the mileage, the current data of the battery, or any combination thereof. For example, the deterioration degree of the battery according to the mileage may be referred to as cycle aging.

In an embodiment, the battery diagnostic apparatus may obtain the deterioration degree of the battery according to the usage time using Equation 2 below.

[Equation 2]

$$f_2(SOC, T, t) = b_1 \exp(b_2 \cdot SOC) \exp\big((b_3 + b_4 \cdot SOC)/T\big) t^{b_5}$$

For example, $f_2(SOC,T,t)$ may indicate the deterioration degree of the battery according to the usage time. $SOC$ may indicate the SOC of the battery. $T$ may indicate the temperature of the battery. $t$ may indicate the usage time of the battery (or the vehicle). $b_1$ may be the coefficient indicating the influence degree of the SOC of the battery, the temperature of the battery, and the usage time of the vehicle on the deterioration degree of the battery. $b_2$ may be the coefficient indicating the influence degree of the SOC of the battery on the deterioration degree of the battery. $b_3$ may be the coefficient indicating the influence degree of the temperature of the battery on the deterioration degree of the battery. $b_4$ may be the coefficient indicating the influence degree of the SOC of the battery and the temperature of the battery on the deterioration degree of the battery. $b_5$ may be the coefficient indicating the influence degree of the usage time of the battery on the deterioration degree of the battery.

In other words, the battery diagnostic apparatus may determine the deterioration degree of the battery according to the usage time, using at least one of the SOC data of the battery, the usage time, the temperature data of the battery, or any combination thereof.

The battery diagnostic apparatus according to an embodiment may obtain ideal data for predicting an SOH of the battery, based on the deterioration degree of the battery according to the mileage and the deterioration degree of the battery according to the usage time. For example, the battery diagnostic apparatus may obtain the ideal data, using Equations 3 and 4.

[Equation 3]

$$Q_{loss} = f_1(I, T, L) + f_2(SOC, T, t)$$

Referring to FIG. 3, $Q_{loss}$ may indicate the lost discharge capacity of the battery.

[Equation 4]

$$SOH_{model} = 1 - Q_{loss}/Q_0$$

Referring to FIG. 4, $Q_0$ may indicate the initial discharge capacity of the battery (e.g., the discharge capacity of the battery, which is identified at a birth of life (BOL) time point). $SOH_{model}$ may indicate the ideal data.

Referring to FIG. 4, when the capacity table is required to calculate the SOH (S420 - Yes), the battery diagnostic apparatus according to an embodiment may determine discharge capacity for each SOC interval in S450. For example, when determining the capacity table (S420 - Yes), the battery diagnostic apparatus according to an embodiment may determine the discharge capacity for each SOC interval in S450.

For example, the battery diagnostic apparatus may determine one or more SOC intervals. The battery diagnostic apparatus may determine discharge capacity corresponding to each of the one or more SOC intervals.

In an embodiment, the battery diagnostic apparatus may determine discharge capacity for each SOC interval, using Equation 5 below.

[Equation 5]

$$Q_{trip_i} = \frac{\int_{soc(i)}^{soc(i+1)} I_{pack}\, dsoc}{3600s} \, [Ah]$$

Referring to Equation 5 above, $Q_{trip_i}$ may indicate the discharge capacity corresponding to the SOC interval (e.g.,

a range from to $soc(i + 1)$). $soc(i)$ may indicate an ith interval (e.g., $\frac{i}{N} \times 100\,[\%]$ ) among the N SOC intervals.

Referring to FIG. 4, in S460, the battery diagnostic apparatus according to an embodiment may update the capacity table. For example, because of obtaining discharge capacity for each SOC interval, which corresponds to the vehicle data, the battery diagnostic apparatus may update the capacity table.

Referring to FIG. 6, a graph 600 illustrating vehicle data obtained by the battery diagnostic apparatus according to an embodiment is illustrated.

Referring to the graph 600, the battery diagnostic apparatus may obtain first vehicle data based on first driving of the vehicle. The battery diagnostic apparatus may obtain a first discharge capacity dataset 601 corresponding to the first vehicle data using the first vehicle data.

For example, the battery diagnostic apparatus may obtain second vehicle data, based on that the vehicle performs second driving after performing the first driving. The battery diagnostic apparatus may obtain a second discharge capacity dataset 602 corresponding to the second vehicle data using the second vehicle data.

In an embodiment, the battery diagnostic apparatus may determine whether the second vehicle data obtained after obtaining the first vehicle data meets predetermined criteria. For example, the predetermined criteria may be set according to a temperature of the battery, a mileage of the vehicle, a driving time of the vehicle, and/or a degree to which battery energy is used.

For example, when the second vehicle data meets the predetermined criteria, the battery diagnostic apparatus may determine whether to update a first discharge capacity dataset 711 corresponding to the first vehicle data to a second discharge capacity dataset 712 corresponding to the second vehicle data.

Referring to FIG. 7, an example 700 for describing an operation for updating a capacity table in the battery diagnostic apparatus according to an embodiment is illustrated.

In the example 700, the battery diagnostic apparatus according to an embodiment may determine a first capacity table 701. The capacity table may comprise a two-dimensional (2D) matrix indicating discharge capacity for each SOC interval, in response to one or more layers. Each of the one or more layers may correspond to a history in which the vehicle drove. The number of the one or more layers may be determined by a setting value. The 2D matrix may be in the form of N (e.g., the number of SOC intervals) x M (e.g., the number of the one or more layers).

For example, a first layer 710 may include the first discharge capacity dataset 711 corresponding to vehicle data, which is most recently obtained. The first discharge capacity dataset 711 may indicate discharge capacity for an SOC interval used while the vehicle is driving. The first discharge capacity dataset 711 may be referred to a first discharge capacity dataset 601 of FIG. 6.

The battery diagnostic apparatus according to an embodiment may move the first discharge capacity dataset 711, which is included in the first layer 710 among the one or more layers and corresponds to first vehicle data, from the first layer 710 to a second layer 720, based on obtaining second vehicle data after obtaining the first vehicle data.

For example, the battery diagnostic apparatus may update the first layer 710 using the second discharge capacity dataset 712 corresponding to the second vehicle data. In other words, the battery diagnostic apparatus may overwrite the second discharge capacity dataset 712 on the first discharge capacity dataset 711 assigned to the first layer 710.

For example, the second discharge capacity dataset 712 may be referred to a second discharge capacity dataset 602 of FIG. 6.

For example, by updating the first layer 710, the battery diagnostic apparatus may obtain a second capacity table 702.

In an embodiment, the battery diagnostic apparatus may determine whether the second vehicle data accumulated (or obtained) after obtaining the first vehicle data meets predetermined criteria. For example, when the second vehicle data meets the predetermined criteria, the battery diagnostic apparatus may determine whether to update the first vehicle data included in the first layer 710 to the second vehicle data. For example, when the second vehicle data does not meet the predetermined criteria, the battery diagnostic apparatus may temporarily suspend updating the first vehicle data to the second vehicle data. For example, when the second vehicle data meets the predetermined criteria, the battery diagnostic apparatus may determine whether to update the first discharge capacity dataset 711 corresponding to the first vehicle data to the second discharge capacity dataset 712 corresponding to the second vehicle data. For example, the battery diagnostic apparatus may determine a time for performing the update. For example, the time for performing the update may include a time point when the driving of the vehicle ends, a time point when the vehicle is ignition off, and/or a specified time. In other words, the battery diagnostic apparatus may update the capacity table, whenever obtaining vehicle data of the vehicle to improve the accuracy of the SOH using the recently obtained vehicle data.

Referring again to FIG. 4, in S470, the battery diagnostic apparatus according to an embodiment may obtain real data.

Referring to FIG. 7, the battery diagnostic apparatus according to an embodiment may obtain the real data, using the second discharge capacity dataset 712 updated in the first layer 710 and the first discharge capacity dataset 721. The first discharge capacity dataset 721 is obtained by moving the first discharge capacity dataset 711 from the first layer 710 to the second layer 720.

In an embodiment, the battery diagnostic apparatus may select an SOC interval for obtaining the real data.

Referring to FIG. 8, a graph 800 illustrating a discharge capacity dataset for each SOC interval and a graph 850 illustrating an average of discharge capacity for each SOC interval are illustrated according to an embodiment. In the graph 800, a first discharge capacity dataset 811 may include the entire data included in a first layer (e.g., a first layer 710 of FIG. 7), in a second capacity table 702 of FIG. 7. A second discharge capacity dataset 812 may include the entire data included in a second layer (e.g., a second layer 720 of FIG. 7), in the second capacity table 702 of FIG. 7.

In an embodiment, the battery diagnostic apparatus may determine an SOC interval 851 for obtaining real data, using the first discharge capacity dataset 811 (e.g., recent data) and the second discharge capacity dataset 812 (e.g., past data).

For example, the battery diagnostic apparatus may learn driving habit of a driver of the vehicle to select the SOC interval 851 for obtaining the real data.

For example, the battery diagnostic apparatus may select the SOC interval 851 for obtaining the real data, using predetermined information.

The battery diagnostic apparatus according to an embodiment may obtain average discharge capacity 852 for the SOC interval 851, based on the first layer (or the first discharge capacity dataset 811) and the second layer (or the second discharge capacity dataset 812).

The battery diagnostic apparatus according to an embodiment may obtain real data, based on the average discharge capacity. For example, the battery diagnostic apparatus may obtain the real data, using Equation 6 below.

[Equation 6]

$$\sum_1^M \sum_A^B SOH_{i,j} \times \frac{N}{(B-A)} \times \frac{1}{Q_0} \times 100[\%]$$

Referring to FIG. 6, $M$ may indicate the identification number of the layer. $A$ may indicate the lower limit value of the SOC interval. $B$ may indicate the upper limit value of the SOC interval. $Q_0$ may indicate the initial discharge capacity. $N$ may indicate the number of the SOC intervals. $SOH_{i,j}$ may be included in the real data. $i$ may indicate the identification number of the SOC interval. $j$ may indicate the identification number of the layer (or the depth of the layer). For example, referring to the second capacity table 702 of FIG. 7, $SOH_{59,1}$ may indicate the discharge capacity (e.g., 1.7).

The battery diagnostic apparatus according to an embodiment may accumulate and store the vehicle data according to the driving history of the vehicle, the ideal data, and/or the real data.

In an embodiment, the battery diagnostic apparatus may extract a representative value for an SOC interval from battery data, based on at least one of the first layer including the first discharge capacity dataset, the second layer including the second discharge capacity dataset, or any combination thereof. For example, the battery diagnostic apparatus may determine the real data based on the representative value.

For example, the representative value may be determined based on at least one of a maximum value, a minimum value, a mean value, a standard deviation, an arithmetic mean, a geometric mean, a harmonic mean, a root mean square, a weighted mean, a mode value, or a median value, or any combination thereof.

Referring to FIG. 9, a table 900 may include information indicating a usage time of vehicle data 902, a mileage 903, and discharge capacity 904 for each SOC interval, which correspond to a driving history 901. For example, the table 900 may include ideal data 903-1 and real data 904-1, which correspond to the driving history 901.

The battery diagnostic apparatus according to an embodiment may provide the real data 904-1 between the ideal data 903-1 and the real data 904-1. For example, when the battery diagnostic apparatus is included in the vehicle, the battery diagnostic apparatus may display a screen indicating the real data 904-1 on a display of the vehicle. For example, when the battery diagnostic apparatus is disposed outside the vehicle, the battery diagnostic apparatus may transmit information indicating the real data 904-1 to the vehicle to provide the real data 904-1.

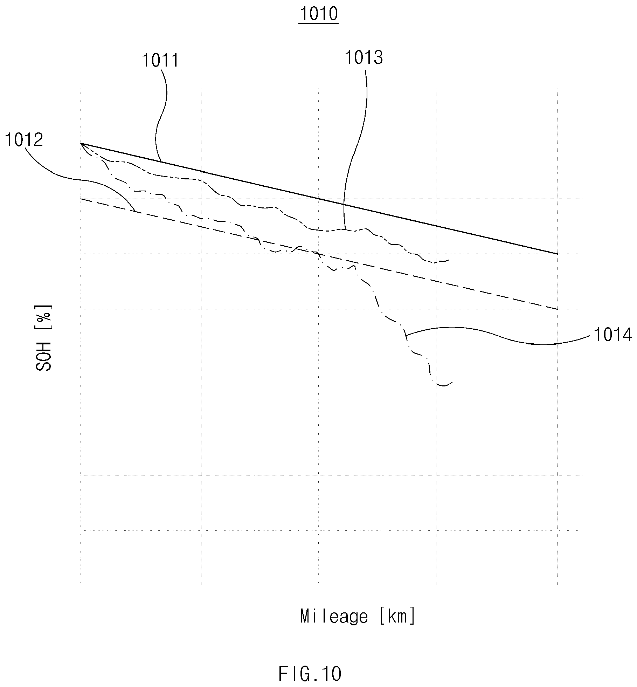

In an embodiment, the battery diagnostic apparatus may obtain the real data 904-1 according to the driving history 901 to provide a deterioration history of the battery. The operation of providing the deterioration history of the battery is described in detail below via a graph 1010 of FIG. 10.

FIG. 5 illustrates a flowchart illustrating an operation of diagnosing a state of a battery in a battery diagnostic apparatus according to an embodiment of the present disclosure.

Referring to FIG. 5, in S510, the battery diagnostic apparatus according to an embodiment may compare ideal data with real data.

For example, the battery diagnostic apparatus may diagnose a state of a battery, using a difference between an SOH corresponding to the ideal data and an SOH corresponding to the real data.

Referring to FIG. 5, in S520, the battery diagnostic apparatus according to an embodiment may determine whether a difference between the real data and a threshold is greater than the ideal data.

Referring to FIG. 5, when the difference between the ideal data and the real data is greater than the threshold (S520 - Yes), in S530, the battery diagnostic apparatus according to an embodiment may diagnose the state of the battery as an abnormal state.

Referring to FIG. 5, when the difference between the ideal data and the real data is less than or equal to the threshold (S520 - No), the battery diagnostic apparatus according to an embodiment may diagnose the state of the battery as a normal state in step S540.

In an embodiment, the battery diagnostic apparatus may determine whether the difference between the ideal data and the real data is within a normal range. For example, when the difference between the ideal data and the real data is within the normal range, the battery diagnostic apparatus may diagnose the state of the battery as the normal state. For example, when the difference between the ideal data and the real data is beyond the normal range, the battery diagnostic apparatus may diagnose the state of the battery as the abnormal state.

FIG. 10 illustrates a graph 1010 illustrating a deterioration history of a battery, which is identified by a battery diagnostic apparatus according to an embodiment of the present disclosure. The graph 1010 may illustrate an SOH for a mileage.

Referring to FIG. 10, the graph 1010 may include a reference SOH 1011 indicating ideal data, a threshold 1012, and a profile of each of real SOHs 1013 and 1014 indicating real data.

For example, the first real SOH 1013 may have a value, which is greater than the threshold 1012. The battery diagnostic apparatus may diagnose a state of the battery corresponding to the first real SOH 1013 as a normal state.

For example, the second real SOH 1014 may have a value, which is less than or equal to the threshold 1012, in at least a portion. The battery diagnostic apparatus may diagnose a state of the battery corresponding to the second real SOH 1014 as an abnormal state, in at least a portion.

When vehicle data corresponding to a driving history is not identified, the battery diagnostic apparatus according to an embodiment may use Equation 7 below to obtain real data.

[Equation 7]

$$\text{Model SOH [\%]} = 1 - \text{coeff\_A} * \text{Mileage} - \text{coeff\_B} * (\text{Aging\_time})\text{coeff\_c}$$

Referring to Equation 7 above, **ModelSOH** may indicate the real data obtained via Equation 7 above. **Mileage** may indicate the mileage. **Aging_time** may indicate the usage time of the vehicle (or the battery). **coeff_A**, **coeff_B,** and **coeff_C** may indicate the coefficients corresponding to the vehicle (or the battery).

As described above, the battery diagnostic apparatus according to an embodiment may obtain the vehicle data according to the driving history. The battery diagnostic apparatus may obtain real data and ideal data using the vehicle data. The battery diagnostic apparatus may determine a state of the battery, using a difference between the real data and the ideal data. The battery diagnostic apparatus may determine the state of the battery using the vehicle data according to the driving history to improve the accuracy of SOH estimation.

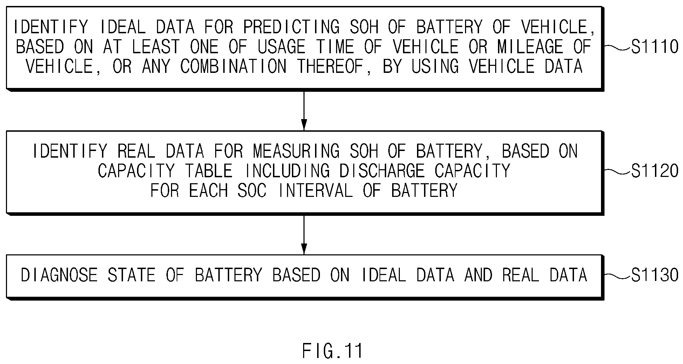

FIG. 11 illustrates a flowchart illustrating a battery diagnostic method according to an embodiment of the present disclosure. Hereinafter, it is assumed that a battery diagnostic apparatus 100 of FIG. 1 performs a process of FIG. 11. In addition, in a description of FIG. 11, it may be understood that an operation described as being performed by an apparatus is controlled by a processor 110 of the battery diagnostic apparatus 100. The respective operations of FIG. 11 may be sequentially performed but are not necessarily sequentially performed. For example, an order of the respective operations may be changed, and at least two operations may be performed in parallel.

Referring to FIG. 11, the battery diagnosis method according to an embodiment may include determining ideal data for predicting an SOH of a battery of a vehicle, based on at least one of a usage time of the vehicle, a mileage of the vehicle, or any combination thereof, by using vehicle data (S1110).

For example, obtaining the vehicle data may be associated with at least one of the operations of FIG. 2.

For example, the battery diagnostic method may further include removing error data from the vehicle data. The removing of the error data may be associated with at least one of the operations of FIG. 3.

For example, the determining of the ideal data may be associated with at least one (e.g., S430 and S440 of FIG. 4) of the operations of FIG. 4.

Referring to FIG. 11, the battery diagnostic method according to an embodiment may include determining real data for measuring an SOH of the battery, based on a capacity table including discharge capacity for each SOC interval of the battery (S1120).

For example, determining the real data may be associated with at least one (e.g., S450 to S470 of FIG. 4) of the operations of FIG. 4.

Referring to FIG. 11, the battery diagnostic method according to an embodiment may include diagnosing a state of the battery based on the ideal data and the real data (S1130).

For example, diagnosing the state of the battery may be associated with at least one of the operations of FIG. 5.

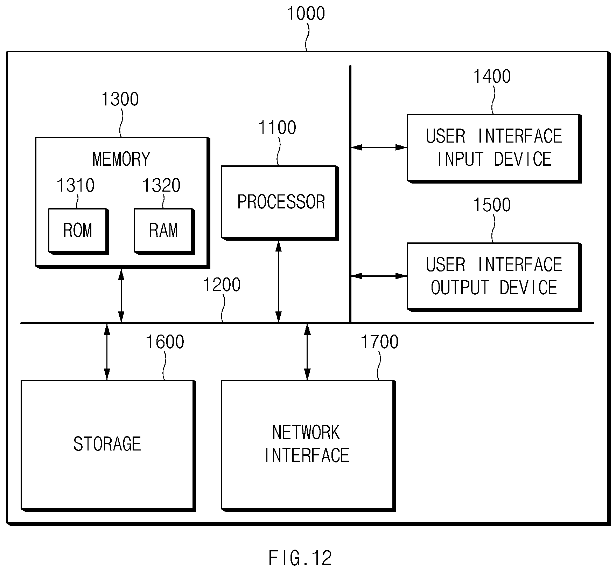

FIG. 12 illustrates a computing system associated with a battery diagnostic apparatus or a battery diagnostic method according to an embodiment of the present disclosure.

Referring to FIG. 12, The computing system 1000 may include at least one processor 1100, a memory 1300, a user interface input device 1400, a user interface output device 1500, a storage 1600, and a network interface 1700 connected through a system bus 1200.

The processor 1100 may be a central processing device (CPU) or a semiconductor device that processes instructions stored in the memory 1300 and/or the storage 1600. The memory 1300 and the storage 1600 may include various types of volatile or non-volatile storage media. For example, the memory 1300 may include a ROM (Read Only Memory) 1310 and a RAM (Random Access Memory) 1320.

Thus, the operations of the method or the algorithm described in connection with the embodiments disclosed herein may be embodied directly in hardware, a software module executed by the processor 1100, or in a combination thereof. The software module may reside on a storage medium (i.e., the memory 1300 and/or the storage 1600) such as a RAM, a flash memory, a ROM, an EPROM, an EEPROM, a register, a hard disk, a removable disk, and a CD-ROM.

The storage medium may be coupled to the processor 1100, and the processor 1100 may read information out of the storage medium and may record information in the storage medium. Alternatively, the storage medium may be integrated with the processor 1100. The processor 1100 and the storage medium may reside in an application specific integrated circuit (ASIC). The ASIC may reside within a user terminal. In another case, the processor 1100 and the storage medium may reside in the user terminal as separate components.

The present technology may update vehicle data to diagnose a deterioration state of the battery.

Furthermore, the present technology may compare a predicted value for a deterioration degree of the battery with a measured value for the deterioration degree of the battery based on a driving history to diagnose a state of the battery.

In addition, various effects ascertained directly or indirectly through the present disclosure may be provided.

Hereinabove, although the present disclosure has been described with reference to embodiments and the accompanying drawings, the present disclosure is not limited thereto but may be variously modified and altered by those having ordinary skill in the art to which the present disclosure pertains without departing from the spirit and scope of the present disclosure claimed in the following claims.

Therefore, embodiments of the present disclosure are not intended to limit the technical spirit of the present disclosure but provided only for the illustrative purpose. The scope of the present disclosure should be construed based on the accompanying claims, and all the technical ideas within the scope equivalent to the claims should be included in the scope of the present disclosure.

**Claims**

1. A battery diagnostic apparatus, comprising:

   a processor configured to:

   determine ideal data for predicting a state of health (SOH) of a battery of a vehicle, based on first vehicle data obtained from the vehicle while the vehicle driving;
   determine real data for measuring the SOH of the battery, based on battery data measured in one or more state of charge (SOC) intervals of the battery;
   diagnose a state of the battery based on the ideal data and the real data;
   update a first capacity table by overwriting a second discharge capacity dataset on a first discharge capacity dataset assigned to a first layer of the first capacity table and moving the first discharge capacity dataset from the first layer of the first capacity table to a second layer of the capacity table; and
   obtain a second capacity table in response to the updated first layer of the first capacity table,

   wherein the first discharge capacity dataset indicates discharge capacity for an SOC interval used while the vehicle is driving.

2. The battery diagnostic apparatus of claim 1, wherein the processor is configured to:

   determine the ideal data, based on at least one of a usage time of the vehicle, a mileage of the vehicle, a parking time of the vehicle, a parking temperature of the vehicle, the SOC, a charge rate (C-rate) of the vehicle, a charge temperature of the vehicle, or any combination thereof,
   wherein the usage time, the mileage, the parking time, the parking temperature, the SOC, the C-rate, and the charge temperature are obtained based on the first vehicle data.

3. The battery diagnostic apparatus of claim 1 or 2, wherein the processor is configured to:

   obtain the second discharge capacity dataset after obtaining the first discharge capacity dataset; and
   determine the real data by using the second discharge capacity dataset updated in a first layer and the first discharge capacity dataset moved to the second layer,

EP 4 764 525 A1

wherein the first layer of the first capacity table and the second layer of the first capacity table indicate the battery data, and

wherein the battery data includes at least one of the discharge capacity for each of the one or more SOC intervals, battery resistance for each of the one or more SOC intervals, or any combination thereof.

4. The battery diagnostic apparatus of anyone of claims 1-3, wherein the processor is configured to:
determine whether second vehicle data obtained after obtaining the first vehicle data meets predetermined criteria.

5. The battery diagnostic apparatus of claim 4, wherein the processor is configured to:
determine whether to update the first discharge capacity dataset corresponding to the first vehicle data to the second discharge capacity dataset corresponding to the second vehicle data, when the second vehicle data meets the predetermined criteria.

6. The battery diagnostic apparatus of anyone of claims 1-5, wherein the processor is configured to:

extract a representative value for the one or more SOC intervals from the battery data, based on at least one of a first layer including the first discharge capacity dataset, a second layer including the second discharge capacity dataset, or any combination thereof; and
determine the real data, based on the representative value.

7. The battery diagnostic apparatus of anyone of claims 1-6, wherein the processor is configured to:
select the one or more SOC intervals for obtaining the real data, using predetermined information.

8. The battery diagnostic apparatus of anyone of claims 1-7, wherein the processor is configured to:
diagnose the state of the battery as a normal state, when a difference between the ideal data and the real data is within a normal range.

9. The battery diagnostic apparatus of anyone of claims 1-8, wherein the processor is configured to:
diagnose the state of the battery as an abnormal state, when a difference between the ideal data and the real data is beyond a normal range.

10. The battery diagnostic apparatus of claim 2, or of anyone of claims 3-9 provided that depending on claim 2, wherein the processor is configured to:

determine a deterioration degree of the battery according to the mileage, using at least one of temperature data of the battery, the mileage, current data of the battery, or any combination thereof, wherein the temperature data, the mileage, and the current data are included in the first vehicle data; and
determine the ideal data, based on the deterioration degree of the battery according to the mileage.

11. The battery diagnostic apparatus of claim 2, or of anyone of claims 3-10 provided that depending on claim 2, wherein the processor is configured to:

determine a deterioration degree of the battery according to the usage time, using at least one of SOC data of the battery, the usage time, temperature data of the battery, or any combination thereof, wherein the SOC data, the usage time, and the temperature data are included in the first vehicle data; and
determine the ideal data, based on the deterioration degree of the battery according to the usage time.

12. A battery diagnostic method, comprising:

determining ideal data for predicting a state of health (SOH) of a battery of a vehicle, based on first vehicle data obtained from the vehicle while the vehicle driving;
determining real data for measuring the SOH of the battery, based on battery data measured in one or more state of charge (SOC) intervals of the battery; and
diagnosing a state of the battery based on the ideal data and the real data;
updating a first capacity table by overwriting a second discharge capacity dataset on a first discharge capacity dataset assigned to a first layer of the first capacity table and moving the first discharge capacity dataset from the first layer of the first capacity table to a second layer of the capacity table; and
obtaining a second capacity table in response to the updated first layer of the first capacity table,

14

wherein the first discharge capacity dataset indicates discharge capacity for an SOC interval used while the vehicle is driving.

13. The battery diagnostic method of claim 12, wherein determining the ideal data includes:

determining the ideal data, based on at least one of a usage time of the vehicle, a mileage of the vehicle, a parking time of the vehicle, a parking temperature of the vehicle, the SOC, a charge rate of the vehicle, a charge temperature of the vehicle, or any combination thereof,
wherein the usage time, the mileage, the parking time, the parking temperature, the SOC, the charge rate, and the charge temperature are obtained based on the first vehicle data.

14. The battery diagnostic method of claim 12 or 13, wherein determining the ideal data includes:

obtaining the second discharge capacity dataset after obtaining the first discharge capacity dataset; and
determining the real data by using the second discharge capacity dataset updated in a first layer and the first discharge capacity dataset moved to the second layer,
wherein the first layer of the first capacity table and the second layer of the first capacity table indicate the battery data, and
wherein the battery data includes at least one of the discharge capacity for each of the one or more SOC intervals, or battery resistance for each of the one or more SOC intervals, or any combination thereof.

15. The battery diagnostic method of anyone of claims 12-14, further comprising:
determining whether second vehicle data obtained after obtaining the first vehicle data meets predetermined criteria.

BATTERY DIAGNOSTIC APPARATUS
100

PROCESSOR
110

MEMORY
120

BATTERY
130

FIG.1

START

COLLECT DATA — S210

No

DOES DRIVING END? — S220

Yes

OBTAIN VEHICLE DATA — S230

END

FIG.2

```
                        ┌─────────────┐
                        │    START    │
                        └──────┬──────┘
                               │
                               ▼
        ┌──────────────────────────────────────┐
        │      IDENTIFY VEHICLE DATA            │ ～S310
        └──────────────────┬───────────────────┘
                           │
                           ▼              S320
                      ╱──────────╲
                    ╱              ╲        Yes
                  ╱  IS ERROR DATA   ╲──────────────┐
                  ╲  IDENTIFIED?     ╱               │
                    ╲              ╱                 │
                      ╲──────────╱                   │
                           │ No                      │
                           ▼              S330       │
                      ╱──────────╲                   │
                    ╱              ╲        Yes       ▼
                  ╱  INCLUDE CHARGE  ╲──────────►┌─────────┐
                  ╲  DATA?           ╱           │   END   │
                    ╲              ╱             └─────────┘
                      ╲──────────╱
                           │ No
                           ▼
                  ┌──────────────────┐
                  │  PERFORM S410    │
                  └──────────────────┘
```

FIG.3

INITIATE TO CALCULATE SOH —S410

IS CAPACITY
TABLE IDENTIFIED? S420

No

Yes

IDENTIFY MILEAGE
AND USAGE TIME —S430

IDENTIFY DISCHARGE CAPACITY
FOR EACH SOC INTERVAL —S450

OBTAIN IDEAL DATA —S440

UPDATE CAPACITY TABLE —S460

OBTAIN REAL DATA —S470

FIG.4

FIG.5

FIG.6

EP 4 764 525 A1

700

FIRST CAPACITY TABLE (701) 710 720

| | 0 | 1 | 2 | 3 | ... | 64 | 65 | 66 | 67 | 68 | 69 | 70 | 71 | ... | 96 | 97 | 98 | 99 |
|---|---|---|---|---|---|---|---|---|---|---|---|---|---|---|---|---|---|---|
| 1 | 1.8 | 1.8 | 1.8 | 1.8 | ... | 1.71 | 1.73 | 1.91 | 1.85 | 1.94 | 1.98 | 1.95 | 2.11 | ... | 1.8 | 1.8 | 1.8 | 1.8 |
| 2 | ... | ... | ... | ... | ... | ... | ... | ... | ... | ... | ... | ... | ... | ... | ... | ... | ... | ... |

711

SECOND CAPACITY TABLE (702)

| | 59 | 60 | 61 | 62 | 63 | 64 | 65 | 66 | 67 | 68 | 69 | 70 | 71 | 72 | 73 | 74 | 75 | ... |
|---|---|---|---|---|---|---|---|---|---|---|---|---|---|---|---|---|---|---|
| 1 | 1.7 | 1.8 | 1.5 | 1.9 | 1.9 | 2.2 | 1.8 | 2.0 | 2.3 | 2.3 | 2.5 | 2.1 | 2.4 | 2.2 | 3.2 | 2.9 | 2.2 | 1.8 |
| 2 | 1.8 | 1.8 | 1.8 | 1.8 | 1.8 | 1.71 | 1.73 | 1.91 | 1.85 | 1.94 | 1.98 | 1.95 | 2.11 | 1.8 | 1.8 | 1.8 | 1.8 | 1.8 |

712

721

FIG.7

FIG.8

900

| Cnt | Trip | | | | | MODEL SOH CALCULATION | | | CLOUD SOH CALCULATION | | | |
|---|---|---|---|---|---|---|---|---|---|---|---|---|
| | Ignition-on | Ignition-off | Avg. Current [A] | Avg. Temperature [°C] | Avg. SOC [%] | Cycle aging [Ah] | Calendar aging [Ah] | Model SOH [%] | $SOH_{1,1}$ [%] | ... | $SOH_{100,10}$ [%] | Cloud SOH [%] |
| 1 | 2022-01-20 09:10:15 | XX | 10 | 25 | 80 | 0.0 | 0.0 | 100 | 1.00 | ... | 1.00 | 100 |
| 2 | 2022-01-22 11:30:25 | XX | 10 | 25 | 70 | 0.1 | 0.1 | 99.9 | 0.98 | ... | 0.98 | 99.9 |
| ... | ... | | | | | ... | ... | ... | ... | ... | | ... |
| 100 | 2023-01-22 12:45:20 | XX | 10 | 25 | 90 | 1.2 | 2.5 | 98.5 | 0.96 | ... | 0.96 | 98.4 |
| ... | ... | | | | | ... | ... | ... | ... | ... | | ... |
| ... | ... | | | | | ... | ... | ... | ... | ... | | ... |

FIG.9

1010

1011    1013

1012

SOH [%]

1014

Mileage [km]

FIG.10

IDENTIFY IDEAL DATA FOR PREDICTING SOH OF BATTERY OF VEHICLE, BASED ON AT LEAST ONE OF USAGE TIME OF VEHICLE OR MILEAGE OF VEHICLE, OR ANY COMBINATION THEREOF, BY USING VEHICLE DATA ~S1110

IDENTIFY REAL DATA FOR MEASURING SOH OF BATTERY, BASED ON CAPACITY TABLE INCLUDING DISCHARGE CAPACITY FOR EACH SOC INTERVAL OF BATTERY ~S1120

DIAGNOSE STATE OF BATTERY BASED ON IDEAL DATA AND REAL DATA ~S1130

FIG.11

1000

1300

MEMORY

1310 1320

ROM    RAM

1100

PROCESSOR

1400

USER INTERFACE
INPUT DEVICE

1500

USER INTERFACE
OUTPUT DEVICE

1200

1600

STORAGE

1700

NETWORK
INTERFACE

FIG.12

Europäisches
Patentamt
European
Patent Office
Office européen
des brevets

# EUROPEAN SEARCH REPORT

**Application Number**

EP 25 18 4809

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2023/132102 A1 (KIM YE KYU [KR] ET AL) 27 April 2023 (2023-04-27) * paragraph [0023] - paragraph [0052] * * figures 1-5 * | 1-15 | INV. G01R31/367 G01R31/382 G01R31/392 |
| A | US 2021/141028 A1 (DU MINGSHU [CN] ET AL) 13 May 2021 (2021-05-13) * paragraph [0061] - paragraph [0091] * * figures 1-5 * | 1-15 | |
| A | US 2022/236329 A1 (HONKURA KOHEI [JP] ET AL) 28 July 2022 (2022-07-28) * paragraph [0025] - paragraph [0027] * * paragraph [0040] - paragraph [0044] * * figures 1,2,5 * | 1-15 | |
| A | XIN XIONG ET AL: "A novel practical state of charge estimation method: an adaptive improved ampere-hour method based on composite correction factor", INTERNATIONAL JOURNAL OF ENERGY RESEARCH, WILEY, CHICHESTER, GB, vol. 44, no. 14, 20 August 2020 (2020-08-20), pages 11385-11404, XP071645765, ISSN: 0363-907X, DOI: 10.1002/ER.5758 * 2. Theoretical analysis * * figures 1-3 * | 1-15 | **TECHNICAL FIELDS SEARCHED (IPC)** G01R |

The present search report has been drawn up for all claims

| Place of search | Date of completion of the search | Examiner |
|---|---|---|
| Munich | 9 December 2025 | Paraf, Edouard |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 25 18 4809

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2025

| Patent document cited in search report | | Publication date | Patent family member(s) | | Publication date |
|---|---|---|---|---|---|
| US 2023132102 | A1 | 27-04-2023 | CN | 116008841 A | 25-04-2023 |
| | | | DE | 102022127910 A1 | 27-04-2023 |
| | | | KR | 102424165 B1 | 25-07-2022 |
| | | | US | 2023132102 A1 | 27-04-2023 |
| US 2021141028 | A1 | 13-05-2021 | CN | 110988690 A | 10-04-2020 |
| | | | EP | 3779484 A1 | 17-02-2021 |
| | | | US | 2021141028 A1 | 13-05-2021 |
| | | | WO | 2020216082 A1 | 29-10-2020 |
| US 2022236329 | A1 | 28-07-2022 | CN | 113994222 A | 28-01-2022 |
| | | | EP | 3982458 A1 | 13-04-2022 |
| | | | JP | 7594528 B2 | 04-12-2024 |
| | | | JP | WO2020246558 A1 | 10-12-2020 |
| | | | US | 2022236329 A1 | 28-07-2022 |
| | | | WO | 2020246558 A1 | 10-12-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240189163